(19) Europäisches Patentamt
European Patent Office
Office européen des brevets

(11) **EP 2 200 046 A1**

(12) **EUROPEAN PATENT APPLICATION**
published in accordance with Art. 153(4) EPC

(43) Date of publication:
**23.06.2010 Bulletin 2010/25**

(51) Int Cl.:
*H01B 5/02* (2006.01)   *C09J 7/02* (2006.01)
*C09J 9/02* (2006.01)   *H01L 31/042* (2006.01)

(21) Application number: **08833301.8**

(22) Date of filing: **25.09.2008**

(86) International application number:
**PCT/JP2008/067333**

(87) International publication number:
**WO 2009/041526 (02.04.2009 Gazette 2009/14)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **26.09.2007   JP 2007249064**

(71) Applicant: **Hitachi Chemical Company, Ltd. Tokyo 163-0449 (JP)**

(72) Inventors:
• **FUKUSHIMA, Naoki Chikusei-shi Ibaraki 308-8524 (JP)**
• **TSUKAGOSHI, Isao Tokyo 108-0023 (JP)**

(74) Representative: **HOFFMANN EITLE Patent- und Rechtsanwälte Arabellastrasse 4 81925 München (DE)**

(54) **CONDUCTOR-CONNECTING MEMBER, METHOD FOR PRODUCING THE SAME, CONNECTION STRUCTURE, AND SOLAR CELL MODULE**

(57)     The conductor-connecting member of the invention is a conductor-connecting member comprising an adhesive layer 3 formed on at least one surface of a metal foil 1, wherein the metal foil 1 comprises a plurality of projections 2 of substantially equal height integrated with the metal foil 1, on the surface on which the adhesive layer 3 is formed, and the adhesive layer 3 fills in the projections 2 so that the surface formed on the side opposite the metal foil 1 is essentially smooth.

*Fig.1*

Printed by Jouve, 75001 PARIS (FR)

**Description**

**Technical Field**

The present invention relates to a conductor-connecting member and a method for producing it, a connection structure and a solar cell, and particularly it relates to a conductor-connecting member that is suitable for connection between solar cells with electrodes and a method for producing it, as well as to a connection structure employing the conductor-connecting member, and a solar cell. The conductor-connecting member of the invention also has a wide range of applications for electrical connection of electrodes that are separated at two points, such as in electromagnetic wave shields and short mode uses.

**Background Art**

Solar cell modules have a construction wherein a plurality of solar cells are connected in series and/or in parallel via wiring members that are electrically connected to their surface electrodes. Solder has traditionally been used for connection between electrodes and wiring members (see Patent document 1, for example). Solder is widely used because of its excellent connection reliability, including conductivity and anchoring strength, low cost and general applicability.

Wiring connection methods that do not employ solder have been investigated, as well, from the viewpoint of environmental protection. For example, Patent documents 2 and 3 disclose connection methods employing paste or film-like conductive adhesives.

[Patent document 1] Japanese Unexamined Patent Publication No. 2004-204256
[Patent document 2] Japanese Unexamined Patent Publication No. 2000-286436
[Patent document 3] Japanese Unexamined Patent Publication No. 2005-101519

**Disclosure of the Invention**

Problems to be Solved by the Invention

In the aforementioned connection method employing solder described in Patent document 1, given a solder melting temperature of generally about 230-260°C, the high temperature of connection and the volume shrinkage of the solder adversely affect the solar cell semiconductor structure, tending to impair the characteristics of the fabricated solar cell module. In addition, the recent decreasing thicknesses of semiconductor boards have tended to result in increased cell cracking and warping. Moreover, because solder connection does not allow easy control of the distance between electrodes and wiring members, it has been difficult to obtain satisfactory dimensional precision for packaging. When sufficient dimensional precision cannot be achieved, product yield tends to be reduced during the packaging process.

On the other hand, methods of establishing connection between electrodes and wiring members using conductive adhesives, as described in Patent documents 2 and 3, allow bonding to be achieved at low temperature compared to using solder, thus potentially reducing the adverse effects on solar cells by heating at high temperature. In order to fabricate a solar cell module by this method, however, it is necessary to repeat a step of first applying or laminating a paste-like or film-like conductive adhesive on a solar cell electrode to form an adhesive layer and then positioning and subsequently bonding a wiring member on the formed adhesive layer, for each electrode. The connection step is therefore complex, resulting in reduced productivity for solar cell modules. The methods described in Patent documents 2 and 3 do not take into account the effect of the surface condition of the adherend, and in some cases it has not been possible to obtain sufficient connection reliability (especially connection reliability with high-temperature, high-humidity).

It is an object of the present invention, which has been accomplished in light of these circumstances, to provide a conductor connecting member which can simplify the connection steps for electrical connection between mutually separate conductors, while also obtaining excellent connection reliability. It is a further object of the invention to provide a connection structure and solar cell module whereby excellent productivity and high connection reliability can both be achieved.

Means for Solving the Problems

In order to achieve the objects stated above, the invention provides a conductor-connecting member having an adhesive layer formed on at least one surface of a metal foil, wherein the metal foil comprises a plurality of projections of substantially equal height integrated with the metal foil, on the surface on which the adhesive layer is formed, and the adhesive layer fills in the projections so that the surface formed on the side opposite the metal foil is essentially smooth.

The conductor-connecting member of the invention has a metal foil serving in place of wiring, and the metal foil is connected and anchored to the conductor as the adherend by the adhesive layer, with the metal foil and adhesive layer being integrated. Using such a conductor-connecting member, connection between the electrode of a solar cell, for example, and the metal foil serving as wiring can be very efficiently accomplished in a single step.

The conductor-connecting member of the invention may be used in place of solder for electrical connection between solar cells with excellent connection reliability, while limiting thermal damage to the solar cells. That is, because the conductor-connecting member of the invention accomplishes connection between a metal foil and a conductor by an adhesive layer, the connection temperature may be a low temperature of 200°C or below and warping of the board is inhibited, while the thickness of the adhesive layer can also be easily controlled since it is formed in a tape-like manner at a constant thickness.

In addition, since the conductor-connecting member of the invention has a plurality of projections of substantially equal height on the metal foil surface, and the adhesive layer fills in the projections so that the surface formed on the side opposite the metal foil is essentially smooth, insufficient filling of the adhesive is eliminated and connection is facilitated while avoiding inclusion of air bubbles during connection to conductors, and low-resistance connection can also be accomplished for superior connection reliability. Furthermore, when excess adhesive seeps out from the joint during connection, a bonding strength-improving effect and a humidity resistance-improving effect, due to the function as a protective layer, are exhibited for enhanced connection reliability. In addition, since the thickness of the adhesive layer may be set in consideration of the surface condition of the conductor as the adherend and only a single connection step is involved, it is possible to accomplish highly efficient connection. Since the side of the metal foil on which the projections, are formed is covered with an adhesive layer in the conductor-connecting member of the invention, the metal foil is resistant to corrosion and stable conductivity can be obtained.

Preferably, the conductor-connecting member of the invention has a distance of no greater than 20 μm from the tip of the projections to the surface of the adhesive layer, and permits electrical conduction between the metal foil and conductor when it is connected to the conductor by hot pressing.

The projections in the conductor-connecting member of the invention have shapes with smaller cross-sectional areas at the tips than the cross-sectional areas at the bases, and are regularly arranged with a center point spacing L between adjacent projection tips in the range of 0.1-5 mm, while the heights H of the projections are preferably less than the center point spacing L. The projections have shapes wherein the cross-sectional areas at the tips are smaller than the cross-sectional areas at the bases, because this facilitates contact between the conductor-connecting member and conductor during connection and allows more reliable low-resistance connection to be established. Also, if they are regularly arranged so that the center point spacing L between adjacent projection tips is in the range of 0.1-5 mm, formation of the projections will be facilitated and stabilized, while the member will be suitable even for connection with small-area conductors and it will be possible to obtain stable and satisfactory conduction between the metal foil and conductor during connection.

The metal foil used in the conductor-connecting member of the invention is preferably one comprising at least one metal selected from the group consisting of Cu, Ag, Au, Fe, Ni, Pb, Zn, Co, Ti, Mg, Sn and Al. This will allow more satisfactory conduction to be obtained between the metal foil and conductor upon connection.

The adhesive layer in the conductor-connecting member of the invention is preferably a layer comprising a thermosetting adhesive composition that contains a latent curing agent. This will allow curing of the adhesive layer at low temperature in a short period of time while also providing storage stability, as well as connection manageability and excellent adhesion by the molecular structure.

In addition, the adhesive layer in the conductor-connecting member of the invention is preferably a layer comprising an adhesive composition that contains conductive particles, wherein the mean particle size of the conductive particles is no greater than the heights of the projections of the metal foil. This will allow high levels of both adhesion and conductivity between the metal foil and conductor to be obtained.

The invention further provides a method for producing a conductor-connecting member according to the invention, the method comprising a step of forming the projections on at least one side of the metal foil, and then laminating an adhesive film on the side of the metal foil on which the projections have been formed to form an adhesive layer.

The invention further provides the aforementioned method for producing a conductor-connecting member according to the invention, which method comprises a step of forming the projections on at least one side of the metal foil, and then casting an adhesive layer-forming solution comprising an adhesive and a solvent and removing the solvent by heating to form an adhesive layer on the side of the metal foil on which the projections have been formed.

The invention still further provides the aforementioned method for producing a conductor-connecting member according to the invention, which method comprises a step of forming the projections on at least one side of the metal foil, and then laminating an adhesive film, or casting an adhesive layer-forming solution comprising an adhesive and a solvent and removing the solvent by heating, to form a first adhesive layer on the side of the metal foil on which the projections have been formed, and subsequently laminating an adhesive film, or casting an adhesive layer-forming solution comprising an adhesive and a solvent and removing the solvent by heating, to form a second adhesive layer on the first adhesive layer, thus forming an adhesive layer comprising the first adhesive layer and second adhesive layer.

A conductor-connecting member of the invention can be efficiently manufactured by these methods for producing a conductor-connecting member.

The invention still further provides a connection structure with the metal foil and conductor electrically connected and bonded, the connection structure being obtained by situating a conductor-connecting member according to the invention and a conductor in such a manner that the side of the metal foil on which the projections have been formed and the conductor are facing each other through the adhesive layer in the conductor-connecting member, and then hot pressing them.

Since a metal foil, as a wiring member, is electrically connected to the conductor by a conductor-connecting member of the invention in the connection structure of the invention, the connection steps can be simplified and excellent connection reliability can be obtained. Such a connection structure according to the invention may be applied to electrical and electronic parts requiring wiring connection (especially solar cell modules), to improve part productivity and enhance connection reliability.

In the connection structure of the invention, the side of the conductor connected to the metal foil preferably has surface roughness, and the projections on the surface roughness sections of the conductor are preferably in contact with the projections on the metal foil. This will increase the number of contact points between the metal foil and conductor, thus allowing a connection structure with lower resistance and higher connection reliability to be obtained.

In the connection structure of the invention, preferably the adhesive layer comprises conductive particles and the conductor and metal foil are electrically connected via the conductive particles. This will increase the number of contact points between the metal foil and conductor, thus allowing a connection structure with lower resistance and higher connection reliability to be obtained.

The invention further provides a solar cell module comprising a plurality of solar cells with surface electrodes, wherein each of the solar cells is electrically connected to the surface electrode via a metal foil bonded with a bonding member, and the metal foil is formed of a conductor-connecting men ber according to the invention described above, where the surface of the metal foil in contact with the surface electrode is the surface on which the projections have been formed.

Since each of the solar cells is connected together via a metal foil formed of a conductor-connecting member according to the invention in the solar cell module of the invention, production is facilitated and excellent connection reliability can be obtained. With the solar cell module of the invention, therefore, it is possible to obtain both excellent productivity and high connection reliability.

In the solar cell module of the invention, preferably the bonding member comprises conductive particles, with the surface electrode and metal foil being electrically connected via the conductive particles. This will increase the number of contact points between the metal foil and the surface electrode, thus allowing a solar cell module with lower resistance and higher connection reliability to be obtained.

In the solar cell module of the invention, preferably the surface of the surface electrode on which the metal foil is to be connected has surface roughness, and the projections on the surface roughness sections of the surface electrode are in contact with the projections of the metal foil to form electrically connected sections, while the sections of the metal foil other than those at the electrically connected sections are essentially covered by the bonding member. This will increase the number of contact points between the metal foil and the surface electrode, thus allowing a solar cell module with lower resistance and higher connection reliability to be obtained.

**Effect of the Invention**

According to the invention it is possible to provide a conductor-connecting member that can simplify the connection steps for electrical connection between mutually separate conductors while also obtaining excellent connection reliability, as well as a method for producing the same. According to the invention it is also possible to provide a connection structure and solar cell module whereby excellent productivity and high connection reliability can both be achieved.

**Brief Description of the Drawings**

Fig. 1 is a schematic cross-sectional view showing an embodiment of a conductor-connecting member according to the invention.

Fig. 2 is a schematic cross-sectional view showing another embodiment of a conductor-connecting member according to the invention.

Fig. 3 is a schematic cross-sectional view showing another embodiment of a conductor-connecting member according to the invention.

Fig. 4 is a schematic cross-sectional view showing another embodiment of a conductor-connecting member according to the invention.

Fig. 5 is a schematic diagram showing an example of an arrangement of projections according to the invention.

Fig. 6 is a schematic diagram showing another example of an arrangement of projections according to the invention.

Fig. 7 is a schematic diagram showing another example of an arrangement of projections according to the invention.

Fig. 8 is a cross-sectional schematic drawing showing a connection structure wherein a conductor-connecting member according to an embodiment is connected to a conductor.

Fig. 9 is a cross-sectional schematic drawing showing a connection structure wherein a conductor-connecting member according to the invention is connected to a conductor.

Fig. 10 is a cross-sectional schematic drawing showing a connection structure wherein a conductor-connecting member according to the invention is connected to a conductor.

Fig. 11 is a schematic view of the essential portion of a solar cell module according to the invention.

Fig. 12 is a schematic cross-sectional view of part of a solar cell module according to the invention.

**Best Mode for Currying Out the Invention**

Preferred embodiments of the invention will now be explained in detail, with reference to the accompanying drawings. Identical or corresponding parts in the drawings will be referred to by like reference numerals and will be explained only once. Unless otherwise specified, the vertical and horizontal positional relationships are based on the positional relationships in the drawings. Also, the dimensional proportions depicted in the drawings are not necessarily limitative.

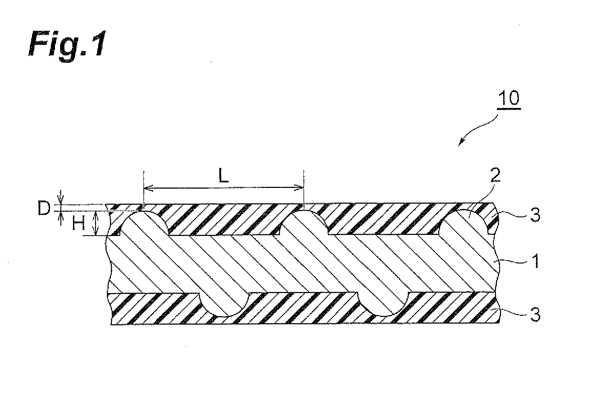

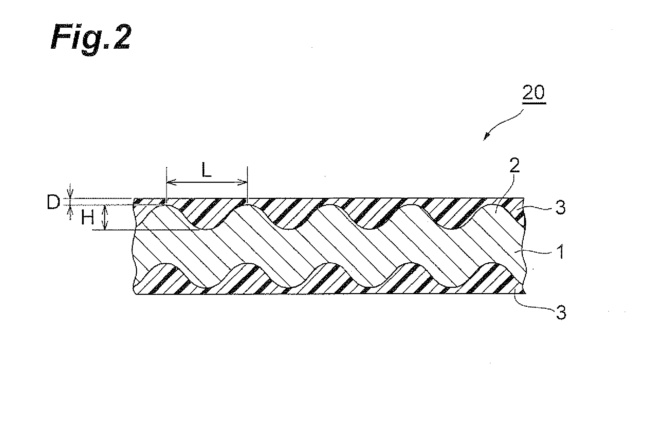

Figs. 1 and 2 are schematic cross-sectional views showing embodiments of conductor-connecting members according to the invention. The conductor-connecting member 10 in Fig. 1 and the conductor-connecting men ber 20 shown in Fig. 2 each comprise a metal foil 1 having projections 2 on both main sides, and adhesive layers 3 formed on either main side of the metal foil 1, and they have the form of an adhesive-attached metal foil tape. The projections 2 are integrated with the metal foil 1, and they have shapes with substantially equal heights. Also, the adhesive layer 3 fills the projections 2, so that the surface formed on the side opposite the metal foil 1 is essentially smooth.

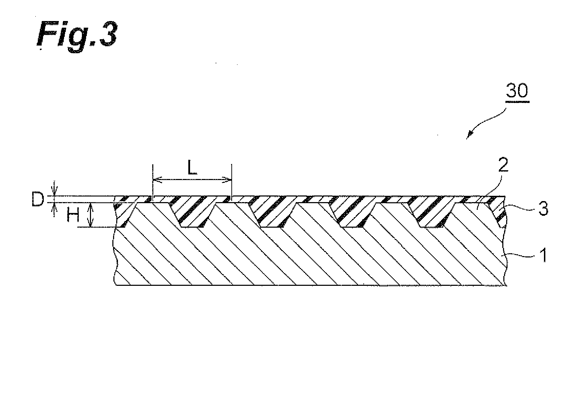

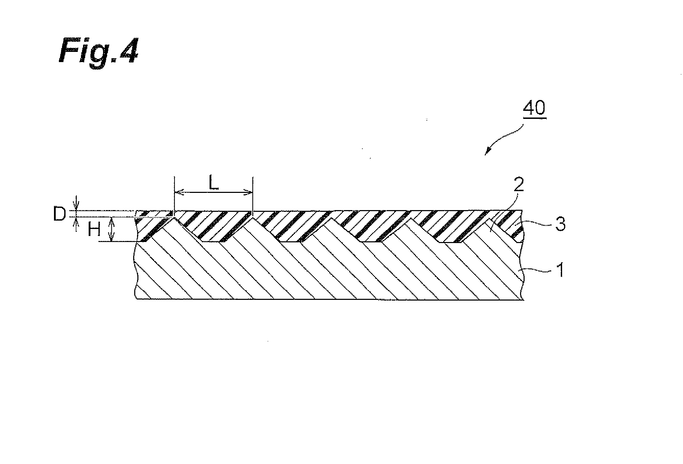

Figs. 3 and 4 are schematic cross-sectional views showing other embodiments of the conductor-connecting member according to the invention. The conductor-connecting member 30 shown in Fig. 3 and the conductor-connecting member 40 shown in Fig. 4 each comprise a metal foil 1 having projections 2 on one main side, with an adhesive layer 3 formed on the main side of the metal foil 1 on which the projections 2 are formed, and they also have the form of an adhesive-attached metal foil tape. The projections 2 are integrated with the metal foil 1, and they have shapes with substantially equal heights. Also, the adhesive layer 3 fills the projections 2, so that the surface formed on the side opposite the metal foil 1 is essentially smooth.

When a conductor-connecting member having the projections 2 and adhesive layers 3 formed on both sides of the metal foil 1 as shown in Fig. 1 and Fig. 2 is used to fabricate a solar cell module as described hereunder, it is easy to carry out the connecting step for connection between the solar cell surface electrode and the surface electrode (rear electrode) formed on the back side of the adjacent solar cell. That is, since adhesive layers 3 are provided on both sides, connection can be established between the surface electrode and rear electrode without reversing the conductor-connecting member.

On the other hand, the conductor-connecting members having the projections 2 and adhesive layer 3 formed on only one side of the metal foil 1 as shown in Fig. 3 and Fig. 4 facilitate formation of the projections 2 and adhesive layer 3 and are superior in terms of cost, and consequently they are also suitable for connection between conductors formed on the same surface.

The conductor-connecting members 10, 20, 30, 40 are in the form of adhesive-attached metal foil tapes, and for winding up into a tape, it is preferred either to provide a separator such as a release sheet on the adhesive layer 3 side or, in the case of the conductor-connecting members 30 and 40, to provide a back side treatment layer of silicon or the like on the back side of the metal foil 1.

The projections 2 preferably have shapes wherein the cross-sectional areas at the tips are smaller than the cross-sectional areas at the bases, because this will facilitate degassing of air bubbles at the interface between the connecting member and the conductor during connection. The cross-sectional area referred to here is the cross-sectional area measured upon cutting a projection 2 in the plane perpendicular to the thickness direction of the metal foil 1. As shown in Figs. 1-4, the projections 2 most preferably have shapes wherein the cross-sectional area decreases from the base toward the tip (a tapered shape).

The projections 2 also are preferably regularly arranged so that the center point spacing L between adjacent projection tips is in the range of 0.1-5 mm. A smaller center point spacing L within this range will be more suited for connection to small-area adherends, while a larger spacing within this range will be more suited when the production step for the projections 2 involves mechanical treatment, and the value may be selected as appropriate for each case.

From the same viewpoint, the center point spacing L is more preferably 0.2-3 mm and especially 0.3-2 mm. The center point spacing L is the center point spacing between the tips of any projection 2 and the projection 2 closest to it. However, the center point spacings between all adjacent projections 2 do not necessarily need to be equal, and they may vary within the aforementioned range.

The heights H of the projections 2 may be set as desired, but a range of about 20-5000 $\mu$m is practical. As shown in Figs. 1-4, the heights H of the projections 2 are the heights from the bases to the tips of the projections 2, and they are preferably values that do not exceed the center point spacing L between adjacent projection tips. This will facilitate formation of the projections 2 and production of the connecting member, while also resulting in easier degassing and satisfactory workability during connection. In addition to the projections 2 of substantially equal height, the metal foil 1 may also have projections or irregularities with lower heights than the projections 2.

According to the invention, the heights H and center point spacings L of the projections 2 may be measured using an ordinary caliper or micrometer, but preferably they are determined by observation of the cross-sections of the projections 2 with a metallurgical microscope or electron microscope.

The metal foil 1 "having projections 2 of substantially equal height" according to the invention means that the metal foil 1 has a plurality of projections whose heights have been intentionally adjusted. From the viewpoint of dimensional precision during formation of the projections 2, the heights of the projections 2 may be completely identical, or the heights of the projections 2 may have a range of error of within $\pm$20% and preferably within $\pm$15%.

There are no particular restrictions on the method of forming the projections 2 on the metal foil 1, and common methods may be employed including physical methods with an abrasive powder of controlled particle size or with a roll, and chemical methods such as plating or etching. According to the invention, a method of embossing by rolling the metal foil with a roll having irregularities formed on the surface is preferred to allow easier formation of the projections 2 of substantially equal height in a regular pattern, while also allowing continuous production of the metal foil 1 for excellent productivity.

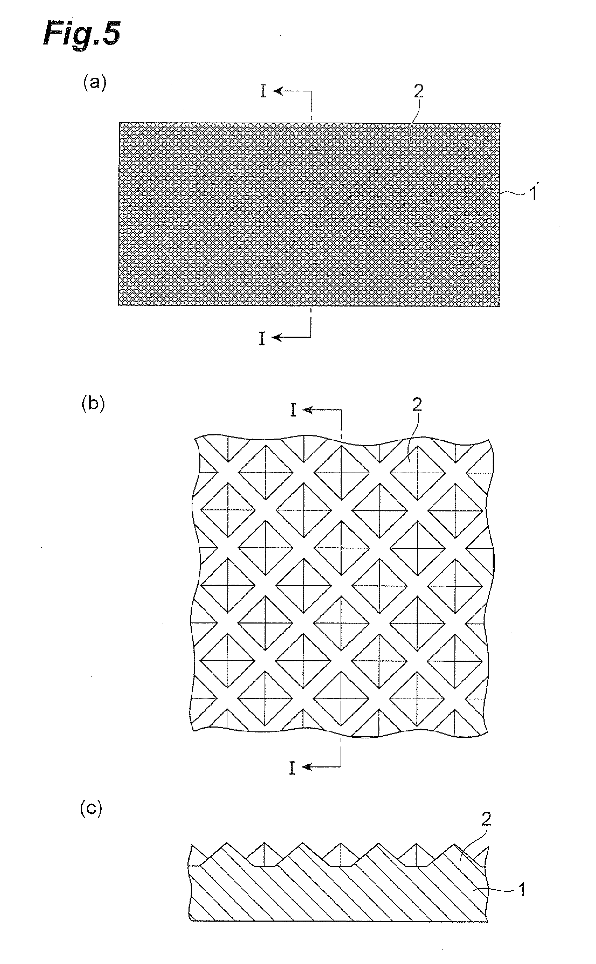

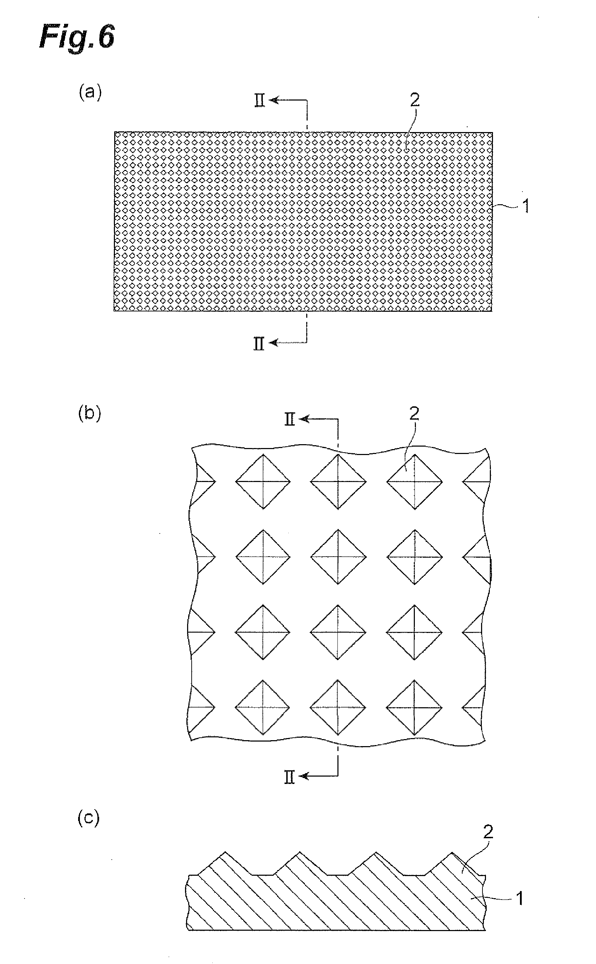

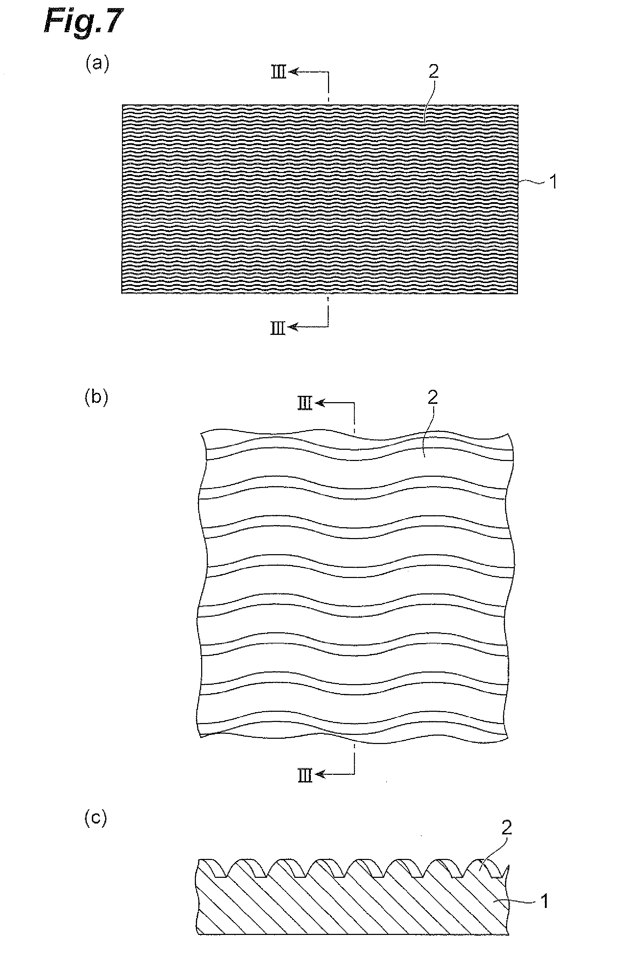

The arrangement pattern of the projections 2 will now be explained with reference to Figs. 5-7. Fig. 5(a) is a plan view schematically showing an example of a projection arrangement, Fig. 5(b) is a partial magnified view of Fig. 5 (a), and Fig. 5(c) is a partial cross-sectional view along line 1-1 of Fig. 5(a). Fig. 6(a) is a plan view schematically showing another example of a projection arrangement, Fig. 6(b) is a partial magnified view of Fig. 6(a), and Fig. 6(c) is a partial cross-sectional view along line II-II of Fig. 6(a). Fig. 7(a) is a plan view schematically showing yet another example of a projection arrangement, Fig. 7(b) is a partial magnified view of Fig. 7(a), and Fig. 7(c) is a partial cross-sectional view along line III-III of Fig. 7(a).

The projections 2 may be independently formed at the vertices of a lattice as shown in Figs. 5 and 6, or they may be undulated as shown in Fig. 7, or linear (not shown). Independent projections will promote conductivity because of the numerous contact points with the adherend upon connection, while continuous projections will facilitate degassing from the interface with the adherend during connection, thus helping to prevent inclusion of air bubbles at the joints.

The two-dimensional shapes of the projections 2 may be circular, ellipsoid, or polygonal such as square, rectangular, triangular, quadrilateral or pentagonal. Circles, ellipsoids and polygons with minimal acute angles are preferred among these from the viewpoint of facilitating production and obtaining excellent degassing properties during connection. On the other hand, acute angles are preferred for penetration of the adhesive layer 3 by the tips of the projections during connection to allow easier contact with the adherend, and for easier low-resistance connection.

When the projections 2 are present on both main sides of the metal foil 1, the shapes and arrangement patterns of the projections 2 on both main sides may be the same or different.

From the viewpoint of conductivity, corrosion resistance and flexibility, the metal foil 1 used may be one comprising at least one metal selected from the group consisting of Cu, Ag, Au, Fe, Ni, Pb, Zn, Co, Ti, Mg, Sn and Al, or a lamination of the foregoing. Copper and aluminum foils which have excellent conductivity are preferred among these.

The thickness of the metal foil 1 is preferably 5-150 $\mu$m. When the conductor-connecting member is wound up as a tape, the thickness of the metal foil 1 is preferably about 20-100 $\mu$m from the viewpoint of deformability and manageability. When the metal foil 1 has a small thickness and lacks strength, it may be reinforced with a plastic film or the like. The thickness of the metal foil 1 is the minimum thickness excluding the heights of the projections 2.

Particularly preferred of the metal foils 1 described above are rolled copper foils used in copper-clad laminates that serve as printed circuit board materials, because they are flexible and they permit easier mechanical working such as embossing, while they are also available as general purpose materials and economical.

The adhesive layer 3 may be a widely used material formed from an adhesive composition comprising a thermoplastic material or a curable material that exhibits curable properties under heat or light. The adhesive layer 3 for this embodiment preferably contains a curable material from the viewpoint of excellent heat resistance and humidity resistance after connection. Thermosetting resins may be mentioned as curable materials, and any publicly known ones may be used. As examples of thermosetting resins there may be mentioned epoxy resins, phenoxy resins, acrylic resins, phenol resins, melamine resins, polyurethane resins, polyester resins, polyimide resins and polyamide resins. From the standpoint of connection reliability, the adhesive layer 3 preferably contains at least one from among epoxy resins, phenoxy resins and acrylic resins.

The adhesive layer 3 preferably comprises a thermosetting resin and a latent curing agent for the thermosetting resin. A latent curing agent has relatively distinct active points for reaction initiation by heat and/or pressure, and is suitable for connection methods that involve heating/pressing steps. The adhesive layer 3 more preferably contains an epoxy resin and a latent curing agent for the epoxy resin. An adhesive layer 3 formed from an epoxy-based adhesive containing a latent curing agent can be cured in a short period of time, has good workability for connection and exhibits excellent adhesion by its molecular structure.

As epoxy resins there may be mentioned bisphenol A-type epoxy resins, bisphenol F-type epoxy resins, bisphenol S-type epoxy resins, phenol-novolac-type epoxy resins, cresol-novolac-type epoxy resins, bisphenol A/novolac-type epoxy resins, bisphenol F/novolac-type epoxy resins, alicyclic epoxy resins, glycidyl ester-type epoxy resins, glycidylamine-type epoxy resins, hydantoin-type epoxy resins, isocyanurate-type epoxy resins, aliphatic straight-chain epoxy resins and the like. The epoxy resins may be halogenated or hydrogenated. These epoxy resins may also be used in combinations of two or more.

As latent curing agents there may be mentioned anionic polymerizable catalyst-type curing agents, cationic polymerizable catalyst-type curing agents and polyaddition-type curing agents. Any of these may be used alone or in mixtures of two or more. Preferred among these are anionic and cationic polymerizable catalyst-type curing agents since they have excellent fast-curing properties and do not require special consideration in regard to chemical equivalents.

As examples of anionic or cationic polymerizable catalyst-type curing agents there may be mentioned tertiary amines, imidazoles, hydrazide-based compounds, boron trifluoride-amine complexes, onium salts (sulfonium salts, ammonium salts, etc.), amineimides, diaminomaleonitrile, melamine and its derivatives, polyamine salts and dicyandiamides, as well as modified forms of the foregoing. As polyaddition-type curing agents there may be mentioned polyamines, polymercaptanes, polyphenols, acid anhydrides and the like.

When a tertiary amine or imidazole is used as an anionic polymerizable catalyst-type curing agent, the epoxy resin is cured by heating at a moderate temperature of about 160°C-200°C for between several tens of seconds and several hours. This is preferred because it lengthens the pot life.

As cationic polymerizable catalyst-type curing agents there are preferred photosensitive onium salts that cure epoxy resins under energy ray exposure (mainly aromatic diazonium salts, aromatic sulfonium salts and the like). Aliphatic sulfonium salts are among those that are activated and cure epoxy resins by heat instead of energy ray exposure. Such curing agents are preferred because of their fast-curing properties.

Microencapsulated forms obtained by covering these curing agents with polyurethane-based or polyester-based polymer substances or inorganic materials such as metal thin-films of nickel or copper, or calcium silicate, are preferred as they can extend the pot life.

The active temperature of the adhesive layer 3 is preferably 40-200°C. If the active temperature is below 40°C, the temperature difference against room temperature (25°C) will be smaller and a low temperature will be required for storage of the connecting member, while if it is above 200°C there will tend to be thermal effects on members other than those in the joints. From the same viewpoint, the active temperature of the adhesive layer 3 is more preferably 50-150°C. The active temperature of the adhesive layer 3 is the exothermic peak temperature upon temperature increase of the adhesive layer 3 as the sample from room temperature at 10°C/min using a DSC (differential scanning calorimeter).

Setting a lower active temperature for the adhesive layer 3 will tend to improve the reactivity but lower the storage life, and therefore it is preferably selected from both these considerations. The conductor-connecting member of this embodiment allows temporary connections to be made on conductors formed on boards, and allows metal foils and adhesive-attached boards to be obtained, by heat treatment at the active temperature of the adhesive layer 3. Furthermore, setting the active temperature of the adhesive layer 3 within the range specified above can ensure an adequate storage life of the adhesive layer 3 while facilitating highly reliable connection upon heating at above the active temperature. This allows more effective two-stage curing wherein temporarily connected articles are collectively cured afterwards. When such temporarily connected articles are produced, there is virtually no viscosity increase in the adhesive layer 3 as curing reaction proceeds at the active temperature, and therefore the microirregularities in the electrodes are completely filled and production can be more easily managed.

While addition of conductive particles is not absolutely necessary because the conductor-connecting member of this embodiment can obtain conductivity in the thickness direction utilizing the irregularities on the surfaces of the projections formed on the metal foil 1 surface, the adhesive layer 3 preferably contains conductive particles from the viewpoint of increasing the number of indentation surfaces during connection to increase the number of contact points.

There are no particular restrictions on the conductive particles, and for example, gold particles, silver particles, copper particles, nickel particles, gold-plated nickel particles, gold/nickel plated plastic particles, copper-plated particles and nickel-plated particles may be mentioned. The conductive particles preferably have burr-shaped or spherical particle shapes from the viewpoint of the filling properties of the conductive particles into the adherend surface irregularities during connection. Specifically, conductive particles in such a form have higher filling properties for complex irregular shapes on metal foil and adherend surfaces, as well as high shape-following properties for variation caused by vibration or expansion after connection, and can therefore improve the connection reliability.

The conductive particles used for this embodiment have a particle size distribution in the range of about 1-50 $\mu$m, and preferably 1-30 $\mu$m.

The content of conductive particles in the adhesive layer 3 may be within a range that does not notably lower the adhesion of the adhesive layer 3, and for example, it may be up to 10 vol% and preferably 0.1-7 vol% based on the total volume of the adhesive layer 3.

When the adhesive layer 3 of the conductor-connecting member of this embodiment contains conductive particles, the mean particle size PD ($\mu$m) of the conductive particles is preferably equal to or smaller than the heights H of the projections 2, from the viewpoint of achieving a high level for both the adhesion and conductivity. This embodiment is characterized by allowing a wide range to be selected for the particle size distribution, because the conductive particles can easily follow the projections 2 of the metal foil 1 or roughness on the adherend.

When the adhesive layer 3 of the conductor-connecting member of this embodiment comprises a latent curing agent, the mean particle size of the latent curing agent is preferably equal to or smaller than the heights H of the projections 2 or the mean particle size PD of the conductive particles. By limiting the mean particle size of the latent curing agent to no greater than the heights of the projections 2 on the metal foil 1 or the mean particle size PD of the conductive particles, as the stable materials that are generally harder than the latent curing agent, it is possible to prevent loss of the latent curing agent function when the conductor-connecting member has been subjected to pressure during storage, and to improve the adhesion while adequately maintaining the storage stability of the conductor-connecting member. These conditions are particularly effective for guaranteeing the storage stability when the conductor-connecting member is a wound-up tape.

Throughout the present specification, the mean particle size PD of the conductive particles is the value determined by the following formula. The mean particle size of the latent curing agent is the value determined in the same manner.

[Equation 1]

$$PD = \sum nd / \sum n$$

Here, n represents the number of particles with maximun diameter d. The method of measuring the particle size may be an electron microscope, optical microscope, Coulter counter or light scattering method, all of which are commonly employed. When the particles have an aspect ratio, d is the center diameter. According to the invention, measurement is preferably conducted on at least 10 particles using an electron microscope.

The adhesive layer 3 may also contain, in addition to the components mentioned above, modifying materials such as silane-based coupling agents, titanate-based coupling agents or aluminate-based coupling agents in order to improve the adhesion or wettability between the curing agent, curing accelerator and substrate, dispersing agents such as calcium phosphate or calcium carbonate in order to improve the dispersibility of the conductive particles, and copper inhibitors or chelate materials to prevent silver or copper migration.

Also, the adhesive layer 3 fills the projections 2, so that the surface formed on the side opposite the metal foil 1 is essentially smooth. "Essentially smooth" means a condition with a basically flat and smooth appearance to the naked eye, and specifically a condition wherein the average roughness of the adhesive surface (according to JIS B0601-1994; ten-point average surface roughness: Rz) is no greater than the distance D from the tips of the projections 2 to the surface of the adhesive layer. The adhesive layer 3 having this structure eliminates the problem of insufficient filling of adhesives, inhibits inclusion of air bubbles during connection to conductors and facilitates connection, while also allowing low-resistance connection and excellent connection reliability to be achieved. Furthermore, when excess adhesive seeps out from the joint during connection, a bonding strength-improving effect and a humidity resistance-improving effect, due to the function as a protective layer, are exhibited for enhanced connection reliability.

From the viewpoint of more easily obtaining conductivity upon connection, the adhesive layer 3 has a distance D, from the tips of the projections 2 to the surface of the adhesive layer, of preferably no greater than 20 $\mu$m, more preferably no greater than 15 $\mu$m and even more preferably no greater than 12 $\mu$m. If the distance D is below this limit, it will be easier to obtain an electrically conductive state between the metal foil 1 and the conductor when connection is established with the conductor by hot pressing. Insufficient coverage of the projections by the adhesive, leaving the projections exposed, is not preferred because it may lead to inconveniences such as electrode corrosion and reduced adhesion.

The distance D from the tips of the projections 2 of the adhesive layer 3 to the surface of the adhesive layer was measured using a micrometer (trade name: ID-C112C by Mitsutoyo Corp.). Specifically, the thickness of the entire conductor connecting member at the tip of a projection may be measured first, and then the thickness of the section of the projection of the metal foil measured after removing the adhesive layer at that section with a solvent, for example, and the distance D determined by the difference between the measured values. At least 3 points are measured and the average value recorded as the distance D.

In order to obtain electrical conduction between the projections 2 and the conductor, the adhesive layer 3 must be removed from between the projections 2 and conductor either by thrusting of the tips of the projections 2 into or their contact with the conductor, or by insulation breakdown under voltage. From this viewpoint as well, it is important to adjust the thickness of the adhesive layer 3. According to conductor-connecting member of this embodiment, the metal foil and conductor are satisfactorily bonded by heated pressure while low resistance conduction of no greater than about $10^{-1}$ $\Omega/cm^2$ is also achieved between the metal foil and conductor during electrification.

The conductor-connecting member of this embodiment may also be provided with a separator on the adhesive layer 3. This will allow the conductor-connecting member to be wound as a roll, while also preventing inclusion of contaminants and adhesion of dust during use. As such separators there may be mentioned polyethylene films, plastic films such as polyethylene terephthalate or polypropylene, and paper.

The conductor-connecting member of the embodiment described above may be placed on the conductor and hot pressed to bond the metal foil and conductor while obtaining electrical conduction between the metal foil and conductor during electrification.

The conductor-connecting member of this embodiment is suitable as a connecting member for connection between multiple solar cells in series and/or parallel.

A method for producing the conductor-connecting member of this embodiment will now be described. The first method for producing a conductor-connecting member may be a method comprising a step of forming projections on at least one side of a metal foil, and then laminating an adhesive film on the side of the metal foil on which the projections have been formed to form an adhesive layer.

The projections may be formed by embossing the metal foil, for example.

The method of smoothing the surface of the adhesive layer may be, for example, a method using a separator-attached adhesive film. A separator with a smooth surface will make it easier for the surface of the side of the adhesive layer opposite the metal foil side to be rendered essentially smooth. Another method is one in which the adhesive film is laminated and then a film having a smooth side is contacted with the surface of the adhesive film opposite the metal foil side.

Releasing the separator at the time of use can more effectively prevent loss of smoothness of the adhesive layer surface during storage.

The first method for producing a conductor-connecting member as described above is preferred especially from the viewpoint of superior mass production, since it improves production workability when forming the adhesive on both sides of the metal foil, and allows the metal foil with projections and the adhesive film to be prepared in advance.

A second method for producing a conductor-connecting member may be a method comprising a step of forming projections on at least one side of a metal foil, and then casting an adhesive layer-forming solution comprising an adhesive and a solvent onto the side of the metal foil on which the projections have been formed and removing the solvent by heating, to form an adhesive layer. This method allows the adhesive layer surface to be smoothed when the solvent has been dried off. That is, the adhesive layer-forming solution reduces the viscosity of the solution and facilitates filling of the areas between the projections, while also allowing a smooth surface to be easily obtained by the flow of the solution from the projections to the recesses under the high drying temperature. If necessary for this embodiment, the surface of the adhesive layer may be further contacted with a smooth-surface film to facilitate obtaining a satisfactory smooth surface. If this film is left to remain as a separator, it will be possible to wind up the conductor-connecting member as a roll, while also preventing inclusion of contaminants and adhesion of dust during use. Releasing the separator at the time of use can more effectively prevent loss of smoothness of the adhesive layer surface during storage.

The adhesive in the adhesive layer-forming solution may be any of the components composing the adhesive layer 3, which were mentioned above. As examples of solvents there may be mentioned ethyl acetate, toluene and methyl ethyl ketone.

The viscosity of the adhesive layer-forming solution may be appropriately selected based on the considerations mentioned above and according to the forming method, but as an example it may be about 10-30,000 MPa·s at 20°C. When a roll coater is used, the viscosity of the adhesive layer-forming solution is preferably about 100-1,000 MPa·s. From the viewpoint of further preventing environmental pollution by reducing solvent emission, and increasing production speed, the solid concentration of the adhesive layer-forming solution is preferably at least 20 wt% and more preferably at least 25 wt% based on the total weight of the solution.

Casting of the adhesive layer-forming solution can be accomplished by a method using a roll coater, knife coater, kiss coater, curtain coater, sprayer or the like.

The conditions for removal of the solvent by heating are preferably heating at a temperature of 70-130°C for 3-30 minutes, from the viewpoint of inhibiting progressive curing of the adhesive and from the viewpoint of production efficiency.

The second method for producing a conductor-connecting member is particularly suitable for forming an adhesive layer on one side of a metal foil, and it is also economically advantageous because of its convenient steps.

A third method for producing a conductor-connecting member may be a method comprising a step of forming the projections on at least one side of the metal foil, and then laminating an adhesive film, or casting an adhesive layer-forming solution comprising an adhesive and a solvent and removing the solvent by heating, to form a first adhesive layer on the side of the metal foil on which the projections have been formed, and subsequently laminating an adhesive film, or casting an adhesive layer-forming solution comprising an adhesive and a solvent and removing the solvent by heating, to form a second adhesive layer on the first adhesive layer, thus forming an adhesive layer comprising the first adhesive layer and second adhesive layer. According to this method, it is possible to precisely adjust the distance D from the tips of the projections 2 to the surface of the adhesive layer by, for example, forming the second adhesive layer by lamination of an adhesive film of thickness D, or casting the adhesive layer-forming solution to a post-drying thickness of D.

A conductor connection structure employing a conductor-connecting member according to this embodiment will now be described.

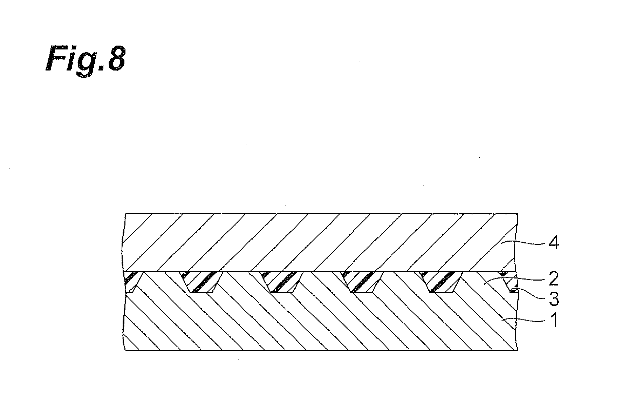

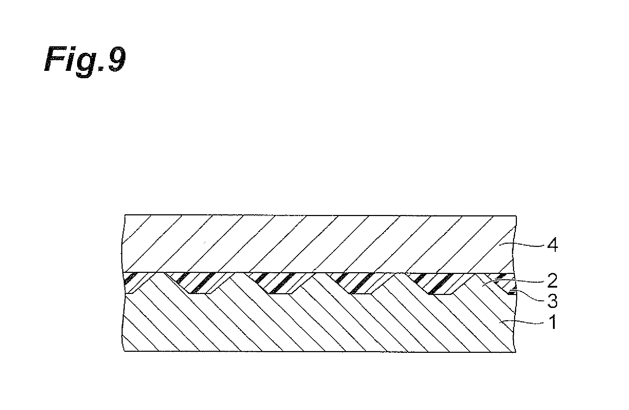

Figs. 8 to 10 are cross-sectional schematic drawings showing connection structures wherein a conductor-connecting member according to this embodiment is connected to a conductor. As seen in Figs. 8 to 10, the projections 2 of the conductor-connecting member in the connection structure of this embodiment are directly contacted with a conductive adherend (conductor) 4 mainly by heated pressing during connection, to establish conduction between the metal foil 1 and conductor 4. That is, the connection structure of this embodiment is a connection structure wherein the projections 2 on the surface of the metal foil 1 of the conductor-connecting member are in contact with the conductor 4, and anchored by the adhesive layer 3. The conductivity obtained by contact between the projections 2 and conductor 4 is fixed and maintained by the adhesive force and curing shrinkage force of the adhesive layer 3. When the adhesive layer 3 contains a curable resin, for example, the adhesive layers 3 in Figs. 8 to 10 may be cured.

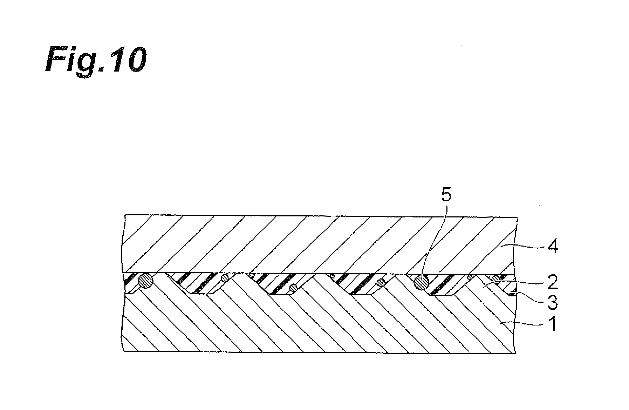

In the connection structure shown in Fig. 10, the adhesive layer 3 comprises conductive particles 5. In this case, the projections 2 and conductor 4 are in direct contact for conduction between the metal foil 1 and conductor 4, while the conductive particles 5 are also present in some sections between the projections 2 and conductor 4, and conduction also takes place between the metal foil 1 and conductor 4 via the conductive particles 5. Thus, the number of contact points is increased by the conductive particles 5 in addition to the contact points between the projections 2 and conductor 4, thus allowing a connection structure with lower resistance and higher connection reliability to be obtained.

The connection structure of this embodiment preferably also has surface roughness on the side of the conductor 4 that is connected with the metal foil 1. This will increase the number of contact points between the projections 2 and conductor 4, thus allowing a connection structure with lower resistance and higher connection reliability to be obtained.

A conductor connection method employing a conductor-connecting member according to this embodiment will now be described.

The conductor connection method of the first embodiment is a method for electrical connection between a mutually separate first conductor and second conductor using a conductor-connecting member comprising the projections 2 and adhesive layer 3 on both sides of the metal foil 1, and it comprises a first step in which part of the conductor-connecting member and a first conductor are laid facing each other and are hot pressed for electrical connection of the metal foil 1 and the first conductor, and a second step in which another part of the conductor-connecting member and a second conductor are laid facing each other and are hot pressed for electrical connection and bonding of the metal foil 1 and second conductor. The first conductor and second conductor thus become electrically connected via the metal foil 1 bonded to the conductors. The conductor connection method of this embodiment is suitable for connection of multiple solar cells in series, for example.

The first step and second step may be carried out simultaneously or in the order of first step and second step, or in the reverse order. In the second step, the side of the conductor-connecting member that is to be connected with the second conductor may be the same side as the side of the conductor-connecting member that is to be connected with the first conductor. This is preferred when, for example, multiple solar cells are connected in parallel.

The conductor connection method of the second embodiment is a method for electrical connection between a mutually separate first conductor and second conductor using a conductor-connecting member comprising the projections 2 and adhesive layer 3 on only one side of the metal foil 1, and it comprises a first step in which part of a conductor-connecting member and a first conductor are situated with the side of the conductor-connecting member having the projections 2 laid facing the first conductor, and these are hot pressed for electrical connection between the metal foil 1 and the first conductor, and a second step in which another part of the conductor-connecting member and a second conductor are situated with the side of the conductor-connecting member having the projections 2 laid facing the second conductor, and these are hot pressed for electrical connection between the metal foil 1 and the second conductor. The first conductor and second conductor thus become electrically connected via the metal foil 1 bonded to the conductors.

The first step and second step may be carried out simultaneously or in the order of first step and second step, or in the reverse order. The conductor connection method of this embodiment is suitable for connection of multiple solar cells in parallel, for example.

As examples of conductors for the conductor connection method of the first embodiment and second embodiment described above, there may be mentioned solar cell bus electrodes, electromagnetic wave shield wiring or ground electrodes, semiconductor electrodes for short modes, and display electrodes.

As known materials that can be used to obtain electrical conduction for solar cell bus electrodes, there may be mentioned ordinary silver-containing glass paste, or silver paste, gold paste, carbon paste, nickel paste or aluminum paste obtained by dispersing conductive particles in adhesive resins, and ITO formed by firing or vapor deposition, but silver-containing glass paste electrodes are preferred from the viewpoint of heat resistance, conductivity, stability and cost. Solar cells generally have an Ag electrode and an A1 electrode formed by screen printing or the like, on a semiconductor board composed of one or more Si single-crystal, polycrystal or amorphous materials. The electrode surfaces generally have irregularities of 3-30 $\mu$m. In most cases, the electrodes formed on solar cells are rough, with a ten-point height of irregularities Rz of 2-18 $\mu$m.

The roughness of an electrode surface is calculated as the ten-point average surface roughness Rz and the maximum height Ry according to JIS B0601-1994, with observation using an ultradepth shape measurement microscope (trade name: VK-8510) by Keyences, and using imaging/analysis software.

The conditions for the heating temperature and pressing pressure are not particularly restricted so long as they are within a range that can ensure electrical connection between the metal foil 1 and conductor 4 and that allows bonding of the conductor 4 and metal foil 1 by the adhesive layer 3. The pressing and heating conditions are appropriately selected according to the purpose of use, the components in the adhesive layer 3 and the material of the substrate on which the conductor 4 is to be formed. For example, when the adhesive layer 3 contains a thermosetting resin, the heating temperature may be a temperature at which the thermosetting resin cures. The pressing pressure may be in a range that sufficiently bonds the conductor 4 and metal foil 1 and does not damage the conductor 4 or metal foil 1. Also, the heating and pressing time may be a time that does not cause excessive" heat transfer to the substrate on which the conductor 4 is formed, to avoid damage to or deterioration of the material. Specifically, the pressing pressure is preferably 0.1 MPa-10 MPa, the heating temperature is preferably 100°C-220°C and the heating/pressing time is preferably no longer than 60 seconds. The conditions are more preferably toward lower pressure, lower temperature and a shorter time.

As explained above, the conductor-connecting member of this embodiment is suitable as a connecting member for connection between multiple solar cells in series and/or parallel. The solar cell may be used as a solar cell module comprising a plurality of photovoltaic cells connected in series and/or in parallel and sandwiched between tempered glass or the like for environmental resistance, and provided with external terminals wherein the gaps are filled with a transparent resin.

As seen in Figs. 8 to 10, the projections 2 of the conductor-connecting member of this embodiment contact with the conductor 4 (cell electrode), or via the conductive particles 5, thus allowing electrical connection between solar cells.

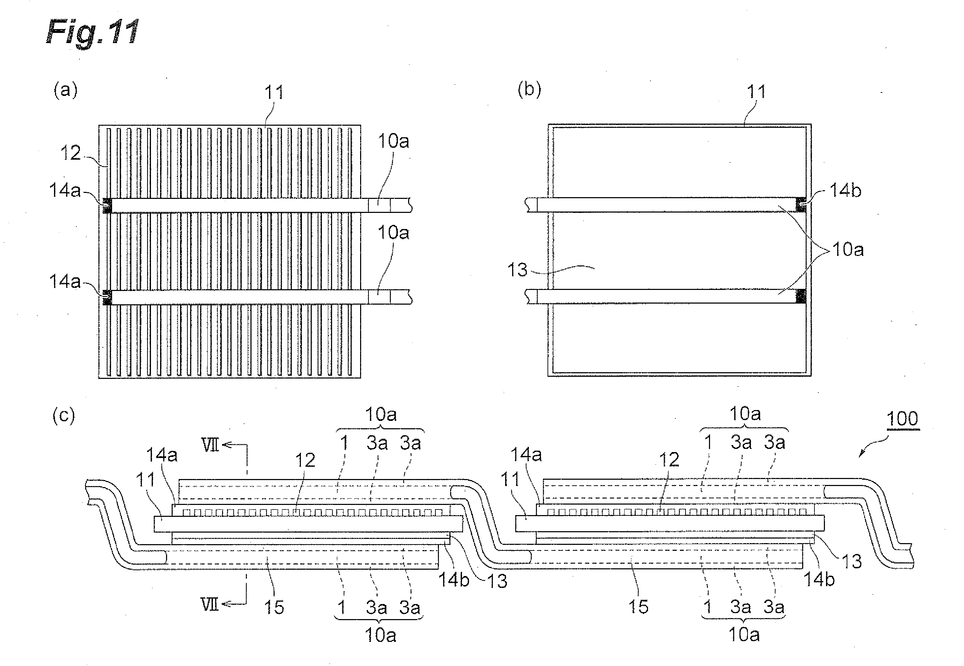

Fig. 11 is a schematic drawing showing the essential parts of a solar cell module according to this embodiment, as an overview of a structure with reciprocally wire-connected solar cells. Fig. 11(a) shows the front side of the solar cell module, Fig. 11(b) shows the rear side, and Fig. 11(c) shows an edge view.

As shown in Figs. 11(a)-(c), the solar cell module 100 has solar cells, with grid electrodes 12 and bus electrodes (surface electrodes) 14a formed on the front side of a semiconductor wafer 11 and rear electrodes 13 and bus electrodes (surface electrodes) 14b formed on the rear side, the solar cells being reciprocally connected by wiring members 10a. The wiring members 10a each have one end connected to a bus electrode 14a as a surface electrode and the other end connected to a bus electrode 14b as a surface electrode. Each of the wiring members 10a is formed using a conductive connecting member 10. Specifically, one end of the conductive connecting member 10 is placed on the bus electrode 14a facing it, and these are hot pressed in the facing direction, while the other end of the conductive connecting member 10 is placed on the bus electrode 14b facing it and these are also hot pressed in the facing direction, to form the wiring member 10a.

According to this embodiment, the metal foil 1 and bus electrode 14a, and the metal foil 1 and bus electrode 14b, may be connected via conductive particles.

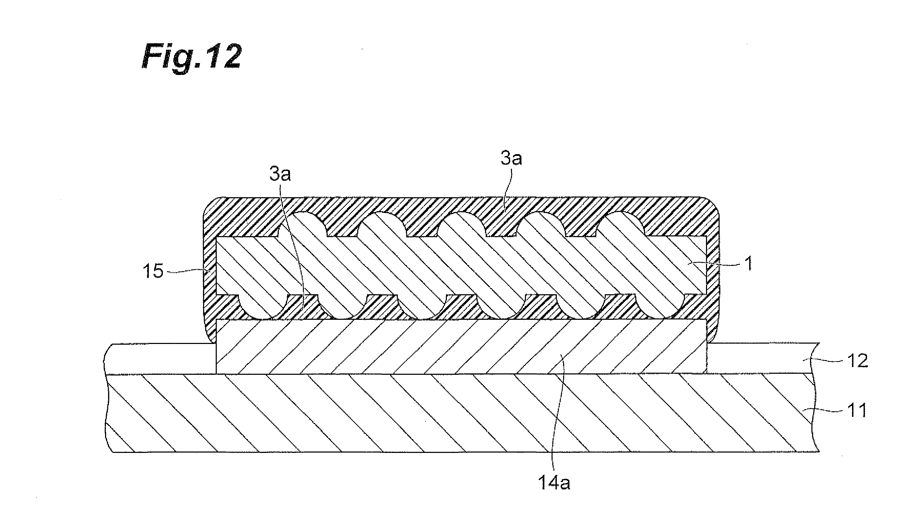

Fig. 12 is a cross-sectional view of the solar cell module shown in Fig. 11(c), along line VII-VII. Fig. 12 shows only the front side of the semiconductor wafer 11, omitting the structure of the rear side. The solar cell module of this embodiment is fabricated through a step in which one end of the conductive connecting member 10 is placed on the bus electrode 14a and hot pressed, and it has a structure wherein the metal foil 1 and bus electrode 14a are electrically connected while the metal foil 1 and bus electrode 14a are bonded by the cured product 3 a of the adhesive layer 3. Also according to this embodiment, the sections of the metal foil 1 other than the surface in contact with the bus electrode 14a are covered by the cured adhesive (preferably resin). Specifically, the side of the metal foil 1 opposite the side in contact with the bus electrode 14a is covered by the cured product 3a of the adhesive layer 3, and the edges of the metal foil 1 are covered by the cured product 15 of the adhesive (excess adhesive) that has seeped out by hot pressing during connection. In this type of structure, electrical shorts due to contact between the metal foil and other conductive members can be effectively prevented, and corrosion of the metal foil can be prevented, and thus improving the durability of the metal foil.

If the conductive connecting member 10 is in the form of a tape as for this embodiment, the width of the member will be extremely small compared to the lengthwise direction and therefore seepage of the adhesive in the direction of the metal foil edges can be increased, thus making it easier to obtain a reinforcing effect on the strength of the joints.

The embodiments described above are preferred embodiments of the invention, but the invention is not limited thereto. The invention may also be applied in a variety of modifications so long as the gist thereof is maintained.

The conductor-connecting member of the invention can be applied not only for fabrication of solar cells as described above, but also for fabrication of, for example, short modes of electromagnetic wave shields, tantalum condensers and the like, aluminum electrode condensers, ceramic condensers, power transistors, various types of sensors, MEMS-related materials and lead wiring members for display materials.

Examples

The present invention will now be explained in greater detail with reference to examples, with the understanding that the invention is not meant to be limited to these examples.

(Example 1)

(1) Fabrication of adhesive-attached metal foil tape (conductor-connecting member)

As a film-forming material, 500 g of a phenoxy resin (trade name: PKHA by Inchem, high molecular weight epoxy resin with molecular weight of 25,000) and 200 g of an epoxy resin (trade name: EPPN, polyfunctional glycidyl ether-type epoxy resin by Nippon Kayaku Co., Ltd.) were dissolved in 1750 g of ethyl acetate to obtain a solution. Next, 50 g of a master batch-type curing agent (trade name: NOVACURE by Asahi Kasei Corp., mean particle size: 2 $\mu$m) comprising imidazole-based microcapsules dispersed in a liquid epoxy resin was added to the solution as a latent curing agent, to obtain an adhesive layer-forming coating solution with a solid content of 30 wt%.

The coating solution for formation of the adhesive layer was coated onto a separator (release-treated polyethylene terephthalate film) and dried at 110°C for 10 minutes to form an adhesive layer. This yielded an adhesive film with an adhesive layer thickness of 200 $\mu$m.

Next, both sides of a rolled copper foil with a thickness of 75 $\mu$m having projections formed on both sides as indicated in Table 1 (projections having hemispherical cross-sections as shown in Fig. 1, formed in a continuous undulating fashion as shown in Fig. 7, with a projection base cross-section diameter (short axis diameter) of 500 $\mu$m, a projection height (H) of 0.5 mm and an adjacent projection center point spacing (L) of 1.5 mm), were laminated with the aforementioned adhesive film using a roll coater while heating at 70°C between the rolls to obtain a laminated body. In this example, the projections were formed on the metal foil before forming the adhesive layer, thus allowing the projections to be prepared under constant conditions beforehand. After releasing the separator, it was confirmed that the surface of the adhesive layer was smoothed. The adhesive layer filled the projections, and the distance from the tips of the projections to the surface of the adhesive layer was 15 $\mu$m. The laminated body had an adhesive layer active temperature of 120°C.

The laminated body was wound up into a roll while taking up a polyethylene film as a separator on the adhesive layer, to obtain a wound roll. The wound roll was cut to a width of 2.0 mm to obtain an adhesive-attached metal foil tape.

(2) Connection of solar cell using adhesive-attached metal foil tape

There were prepared a solar cell (thickness: 150 $\mu$m, size: 15 cm $\times$ 15 cm) comprising a surface electrode (width: 2 mm $\times$ length: 15 cm, ten-point average surface roughness Rz: 12 $\mu$m, maximum height Ry: 13 $\mu$m) formed from silver glass paste on the surface of a silicon wafer.

Next, the obtained adhesive-attached metal foil tape was positioned on a solar cell surface electrode and a contact-bonding tool (AC-S300 by Nikka Equipment & Engineering Co., Ltd.) was used for hot pressing at 170°C, 2 MPa, 20 seconds to accomplish bonding. This yielded a connection structure wherein the copper foil wiring member was connected to the solar cell surface electrode via the conductive adhesive film.

(Example 2)

An adhesive-attached metal foil tape was obtained in the same manner as Example 1, except for adding 2 vol% of burr-shaped Ni powder with a particle size distribution width of 1-15 $\mu$m (mean particle size: 7 $\mu$m) to the adhesive layer-forming coating solution. The adhesive-attached metal foil tape was used to obtain a connection structure in the same manner as Example 1. The added conductive particles are particles that have not been treated for uniformity of particle size, and thus have a wide particle size distribution as explained above.

(Example 3)

An adhesive-attached metal foil tape was obtained in the same manner as Example 1, except that as the metal foil there was used a 35 $\mu$m-thick rolled copper foil having projections formed on one side as indicated in Table 1 (the projections having trapezoid shapes as shown in Fig. 3 and being formed in a lattice as shown in Fig. 6, with a trapezoidal projection base cross-section which was square with 1 mm sides and a tip cross-section which was square with 500 $\mu$m sides, and with a projection height (H) of 0.1 mm and an adjacent projection center point spacing (L) of 1.3 mm), and an adhesive film with an adhesive layer thickness of 80 $\mu$m was laminated on the projection-formed side of the copper foil. The adhesive layer filled the projections, and the distance from the tips of the projections to the surface of the adhesive layer was 5 $\mu$m.

The adhesive-attached metal foil tape was then positioned on a surface electrode with the projection-formed side and surface electrode facing each other, and a connection structure was obtained in the same manner as Example 1.

(Example 4)

A rolled copper foil was prepared in the same manner as Example 3. A roll coater was used for casting of the adhesive layer-forming coating solution of Example 1 on the projection-formed side of a copper foil, and the coating was dried at 110°C for 5 minutes. For the drying, the coated film was cast from the projections of the metal foil toward the base sections (recesses) at high temperature and the solvent was removed by drying to smooth the surface of the coated film. Thus, a laminated body was obtained having an adhesive layer with a smooth surface formed on the metal foil.

The laminated body was wound up into a roll while taking up a polyethylene film as a separator on the adhesive layer, to obtain a wound roll in the same manner as Example 1. This method can help prevent inclusion of contaminants such as dust at the interface between the metal foil and the adhesive layer. In this method, the thickness of the adhesive layer can be easily adjusted by varying the roll gap during application of the adhesive layer-forming coating solution or the solid concentration of the adhesive layer-forming coating solution, to allow usage for more precise specifications. The adhesive layer of this example was formed filling the projections, and the distance from the tips of the projections to the surface of the adhesive layer was 5 $\mu$m.

The adhesive-attached metal foil tape was then positioned on the surface electrode with the projection-formed side and surface electrode facing each other, and a connection structure was obtained in the same manner as Example 1,

(Example 5)

An adhesive-attached metal foil tape was obtained in the same manner as Example 4, except that the projections formed on the metal foil surface had an adjacent projection center point spacing (L) of 3 mm and a projection height (H) of 1 mm. The adhesive-attached metal foil tape was used to obtain a connection structure in the same manner as Example 1. The adhesive layer was formed filling the projections, and the distance from the tips of the projections to the surface of the adhesive layer was 12 $\mu$m.

(Example 6)

An adhesive-attached metal foil tape was obtained in the same manner as Example 5, except that the metal foil was changed to a 50 $\mu$m-thick aluminum foil. The adhesive-attached metal foil tape was used to obtain a connection structure in the same manner as Example 1. Formation of the projections was facilitated because aluminum foil is relatively soft. The adhesive layer was formed filling the projections, and the distance from the tips of the projections to the surface of the adhesive layer was 12 $\mu$m.

(Comparative Example 1)

An adhesive-attached metal foil tape was obtained in the same manner as Example 3, except that a 35 $\mu$m-thick rolled copper foil prior to projection formation was directly used as the metal foil, and an adhesive layer was formed on one side thereof. A connection structure was obtained in the same manner as Example 3 except for using this adhesive-attached metal foil tape.

(Comparative Example 2)

An adhesive-attached metal foil tape was obtained in the same manner as Example 3, except that an adhesive film with an adhesive layer thickness of 40 μm was used. The adhesive layer did not fill the projections, and the distance from the base of the metal foil to the surface of the adhesive layer was 40 μm. The tops of the projections were exposed.

<Evaluation>

The connection structures of Examples 1-6 and Comparative Examples 1-2 were evaluated based on deltaF.F., in the following manner. The results are shown in Table 1.

[deltaF.F.]

The IV curve of the obtained connection structure was measured using a solar simulator (trade name: WXS-155S-10 by Wacom Electric Co., Ltd., AM: 1.5 G). The connection structure was also allowed to stand for 1500 hours in a high-temperature, high-humidity atmosphere at 85°C, 85% RH, and the IV curve was then measured in the same manner. The F.F was derived from each IV curve, and the value of [F.F.(0 h)-F.F.(1500 h)], as the F.F. value before standing in the high-temperature, high-humidity atmosphere minus the F.F. value after standing in the high-temperature, high-humidity conditions, was recorded as Delta(F.F.) and used as the evaluation index. A Delta(F.F.) value of 0.2 or smaller is generally regarded as satisfactory connection reliability.

[Evaluation of connection structure production yield, adhesive layer moldability and metal foil tape moldability]

The connection structure production yield, adhesive layer moldability and metal foil tape moldability were evaluated for Examples 1-6. All of Examples 1-6 exhibited satisfactory connection structure production yield, adhesive layer moldability and metal foil tape moldability. Also, since the connection temperature in Examples 1-6 was a lower temperature (170°C) than the conventional soldering connection temperature (240°C), no board warping was observed. The connection structures of Examples 1-6 also had satisfactory conductivity and adhesion. In Comparative Example 1, on the other hand, the metal foil had no projections and therefore contact between the metal projections and surface electrode was difficult and conductivity could not be obtained. In Comparative Example 2, the projections were exposed up to about the upper halves, and therefore while the initial conductivity was satisfactory, the Delta(F.F.) value was large and the structure was poorly suited for practical use. The reason for this may be that bonding between the metal foil and surface electrode was insufficient.
[Table 1]

| | Metal foil | | | Projections | | | | | Adhesive layer | | Evacuation results |
|---|---|---|---|---|---|---|---|---|---|---|---|
| | Material | Thickness (μm) | Adhesive layer-formed side | Shape | Arrangement pattern | Distance L (mm) | Height H (mm) | Conductive particles | Distance from tips of projections to adhesive layer surface (μm) | -Delta(F. F. ) [F. F. (1500h) -F. F. (Oh)] |
| Example 1 | Cu | 75 | Broth | Hemispherical | Undulated | 1.5 | 0.5 | Absent | 15 | 0.05 |
| Example 2 | Cu | 35 | Both | Hemispherical | Undulated | 1.5 | 0.5 | Present | 15 | 0.05 |
| Example 3 | Cu | 35 | One | Trapezoidal | Lattice | 1.3 | 0.1 | Absent | 5 | 0.02 |
| Example 4 | Cu | 35 | One | Trapezoidal | Lattice | 1.3 | 0.1 | Absent | 5 | 0.02 |
| Example 5 | Cu | 35 | One | Trapezoidal | Lattice | 3 | 1.0 | Absent | 12 | 0.04 |
| Example 6 | A1 | 50 | One | Trapezoidal | Lattice | 3 | 1.0 | Absent | 12 | 0.04 |
| Comp. Ex. 1 | Cu | 35 | One | - | - | - | - | - | 80[*1] | Unmeasurable |
| Comp. Ex. 2 | Cu | 35 | One | Trapezoidal | Lattice | 0.3 | 0.1 | Absent | 40[*2] | 0.5 |

[*1]: Thickness of adhesive layer.
[*2]: Distance from metal foil base to adhesive layer surface.

As demonstrated by the results described above, the present invention can provide an adhesive-attached metal foil tape (conductor-connecting member) which, as a substitute for solder, reduces thermal damage to solar cells and establishes electrical conduction between high-reliability solar cells by hot pressing, and a method for producing it, as well as a connection structure and solar cell employing the adhesive-attached metal foil tape.

According to the adhesive-attached metal foil tape of the invention it is possible to accomplish connection between electrodes and wiring members with an adhesive and to lower the connection temperature to below 200°C, while also inhibiting warping of boards. Also, a tape-like adhesive layer facilitates control of the thickness because it fills the projections of the metal foil and forms a smooth surface on the side opposite the metal foil. Furthermore, since the thickness of the adhesive layer may be set in consideration of the surface condition of the adherend and only a single connection step is necessary to connect electrodes and wiring members with the adhesive, it is possible to accomplish highly efficient connection.

**Industrial Applicability**

Thus, according to the invention it is possible to provide a conductor-connecting member that can simplify the connection steps for electrical connection between mutually separate conductors while also obtaining excellent connection reliability, as well as a method for producing the same. According to the invention it is also possible to provide a connection structure and solar cell module whereby excellent productivity and high connection reliability can both be achieved.

**Claims**

1.   A conductor-connecting member having an adhesive layer formed on at least one surface of a metal foil, wherein the metal foil comprises a plurality of projections of substantially equal height integrated with the metal foil, on the surface on which the adhesive layer is formed, and the adhesive layer fills the projections to form a substantially smooth surface on the side opposite the metal foil side.

2.   The conductor-connecting member according to claim 1, wherein the distance from the tips of the projections to the surface of the adhesive layer is no greater than 20 $\mu$m, and electrical conduction can be established between the metal foil and conductor when it is connected to the conductor by hot pressing.

3.   The conductor-connecting member according to claim 1 or 2, wherein the projections have shapes with smaller cross-sectional areas at the tips than the cross-sectional areas at the bases, and are regularly arranged with a center point spacing L between adjacent projection tips in the range of 0.1-5 mm, and the heights H of the projections are less than the center point spacing L.

4.   The conductor-connecting member according to any one of claims 1 to 3, wherein the metal foil is one comprising at least one metal selected from the group consisting of among Cu, Ag, Au, Fe, Ni, Pb, Zn, Co, Ti, Mg, Sn and Al.

5.   The conductor-connecting member according to any one of claims 1 to 4, wherein the adhesive layer is a layer comprising a thermosetting adhesive composition that contains a latent curing agent.

6.   The conductor-connecting member according to any one of claims 1 to 5, wherein the adhesive layer is a layer comprising an adhesive composition that contains conductive particles, the mean particle size of the conductive particles being no greater than the heights of the projections of the metal foil.

7.   A method for producing the conductor-connecting member according to any one of claims 1 to 6, the method comprising a step of forming the projections on at least one side of the metal foil, and then laminating an adhesive film on the side of the metal foil on which the projections have been formed to form the adhesive layer.

8.   A method for producing the conductor-connecting member according to any one of claims 1 to 6, the method comprising a step of forming the projections on at least one side of the metal foil, and then casting an adhesive layer-forming solution comprising an adhesive and a solvent onto the side of the metal foil on which the projections have been formed and heating it to remove the solvent, to form the adhesive layer.

9. A method for producing the conductor-connecting member according to any one of claims 1 to 6, the method comprising

a step of forming the projections on at least one side of the metal foil, and then laminating an adhesive film, or casting an adhesive layer-forming solution comprising an adhesive and a solvent and removing the solvent by heating, to form a first adhesive layer on the side of the metal foil on which the projections have been formed, and subsequently laminating an adhesive film, or casting an adhesive layer-forming solution comprising an adhesive and a solvent and removing the solvent by heating, to form a second adhesive layer on the first adhesive layer, thus forming the adhesive layer comprising the first adhesive layer and second adhesive layer.

10. A connection structure comprising a metal foil and a conductor that are electrically connected, the structure being obtained by situating the conductor-connecting member according to any one of claims 1 to 6 and a conductor so that the side of the metal foil of the conductor-connecting member on which the projections have been formed faces the conductor via the adhesive layer, and hot pressing them.

11. The connection structure according to claim 10, wherein the side of the conductor connected to the metal foil has surface roughness, and the projections on the surface roughness sections of the conductor are in contact with the projections of the metal foil.

12. The connection structure according to claim 10 or 11, wherein
the adhesive layer comprises conductive particles, and
the electric conductor and metal foil are electrically connected via the conductive particles.

13. A solar cell module comprising a plurality of solar cells with surface electrodes, wherein
each of the solar cells is electrically connected to the surface electrode via a metal foil bonded with a bonding member,
the metal foil is formed of the conductor-connecting member according to any one of claims 1 to 6, and
the surface of the metal foil in contact with the surface electrode is the surface on which the projections have been formed.

14. The solar cell module according to claim 13, wherein
the bonding member comprises conductive particles, and
the surface electrode and metal foil are electrically connected via the conductive particles.

15. The solar cell module according to claim 13 or 14, wherein the surface of the surface electrode on which the metal foil is to be connected has surface roughness,
the projections on the surface roughness sections of the surface electrode are in contact with the projections of the metal foil to form electrically connected sections, and
the sections of the metal foil other than those at the electrically connected sections are essentially covered by the bonding member.

## Fig.1

*Fig.2*

# Fig.3

## Fig.4

# *Fig.5*

(a)

(b)

(c)

# *Fig.6*

(a)

II ←

2

1

II ←

(b)

II ←

2

II ←

(c)

2

1

# *Fig.7*

(a)

(b)

(c)

Fig.8

# Fig.9

*Fig.10*

Fig.11

*Fig.12*

## INTERNATIONAL SEARCH REPORT

| International application No. |
| --- |
| PCT/JP2008/067333 |

A.   CLASSIFICATION OF SUBJECT MATTER
*H01B5/02*(2006.01)i, *C09J7/02*(2006.01)i, *C09J9/02*(2006.01)i, *H01L31/042* (2006.01)i

According to International Patent Classification (IPC) or to both national classification and IPC

B.   FIELDS SEARCHED

Minimum documentation searched (classification system followed by classification symbols)
H01B5/02, C09J7/02, C09J9/02, H01L31/042

Documentation searched other than minimum documentation to the extent that such documents are included in the fields searched
Jitsuyo Shinan Koho         1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| X<br>Y<br>A | JP 2000-248235 A  (Nitto Denko Corp.),<br>12 September, 2000 (12.09.00),<br>Claims; Par. Nos. [0010] to [0018]; Fig. 1<br>(Family: none) | 1-2,4-5,7,<br>10,12<br>8,13-14<br>3,6,9,11,15 |
| X<br>Y<br>A | Microfilm of the specification and drawings annexed to the request of Japanese Utility Model Application No. 30618/1982(Laid-open No. 135445/1983)<br>(Hitachi Chemical Co., Ltd.),<br>12 September, 1983 (12.09.83),<br>Claims; page 3, line 4 to page 4, line 12;<br>table 1; Figs. 1 to 2<br>(Family: none) | 1-2,4-5,8,<br>10,12<br>13-14<br>3,6-7,9,11,<br>15 |

☒   Further documents are listed in the continuation of Box C.          ☐   See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>11 November, 2008 (11.11.08) | Date of mailing of the international search report<br>25 November, 2008 (25.11.08) |
| --- | --- |
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/067333

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2002-97424 A  (3M Innovative Properties Co.), 02 April, 2002 (02.04.02), Claims; Par. No. [0042] & EP 1315780 A | 8 |
| Y | JP 2006-286838 A  (Sanyo Electric Co., Ltd.), 19 October, 2006 (19.10.06), Par. No. [0034]; Fig. 1 & EP 1708280 A1 | 13-14 |
| Y | JP 2006-286789 A  (Sanyo Electric Co., Ltd.), 19 October, 2006 (19.10.06), Par. No. [0021]; Fig. 1 (Family: none) | 13-14 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004204256 A
- JP 2000286436 A

- JP 2005101519 A